# EUROPÄISCHE PATENTANMELDUNG

(11) **EP 2 352 171 A1**
(43) Veröffentlichungstag der Anmeldung: **03.08.2011**
(21) Anmeldenummer: 10152086.4
(22) Anmeldetag: 29.01.2010
(51) Int. Cl.: H01L 31/0336, H01L 27/142, H01L 31/18

(54) **Solarzellenanordnung und Dünnschichtsolarmodul, sowie Herstellungsverfahren hierfür**

(71) Anmelder: Saint-Gobain Glass France, 92400 Courbevoie (FR)
(72) Erfinder: Dr. Philipp, Jan Boris, 81739, München (DE); Dr. Happ, Thomas, 81739, München (DE)
(74) Vertreter: Lendvai, Tomas

(57) **Zusammenfassung**

Die Erfindung betrifft eine Solarzellenanordnung, die insbesondere in Form eines Dünnschichtsolarmoduls ausgebildet sein kann, welche umfasst: ein Substrat, auf dem ein über mehrere Schichten verfügender Schichtenaufbau aufgebracht ist, wobei der Schichtenaufbau eine erste Elektrodenschicht, eine zweite Elektrodenschicht und eine zwischen den beiden Elektrodenschichten angeordnete Halbleiterschicht aufweist, durch die ein pn-Übergang gebildet ist, wobei der Schichtenaufbau in eine Mehrzahl verschiedener Bereiche unterteilt ist, die durch einen oder mehrere Bereichsgräben elektrisch voneinander getrennt sind, wobei in jedem Bereich ein Solarzellenstrang ausgebildet ist, der aus einer oder mehreren seriell verschalteten, gleichgerichteten Solarzellen besteht; einen ersten Anschlusskontakt und einen zweiten Anschlusskontakt, die durch die Solarzellenstränge elektrisch miteinander verbunden sind, wobei die Solarzellenstränge durch einen oder mehrere Zwischenkontakte seriell verschalten sind; zumindest ein Anschlussgehäuse an das die beiden Anschlusskontakte angeschlossen sind. Ein Herstellungsverfahren hierfür umfasst eine Strukturierung des Schichtenaufbaus mittels dreier Strukturierungslinien, wobei eine Strukturierungslinie einen geradlinigen Verlauf über zumindest zwei elektrisch voneinander getrennte Bereiche hinweg aufweist, während die beiden übrigen Strukturierungslinien diese Strukturierungslinie so versetzt sind, dass eine Abfolge der Strukturierungslinien umgekehrt wird.

## Beschreibung

Die Erfindung betrifft eine Solarzellenanordnung mit integrierten, seriell verschalteten Solarzellen, insbesondere zur Verwendung für Dünnschichtsolarmodule, sowie ein Verfahren zur deren Herstellung.

Solarmodule zur photovoltaischen Umwandlung von Sonnenlicht in elektrische Energie werden zunehmend zur Energieerzeugung eingesetzt. Hinsichtlich des Wirkungsgrads haben sich Dünnschichtsolarmodule auf Basis polykristalliner Chalkopyrit-Halbleiter als vorteilhaft erwiesen, wobei sich insbesondere Kupfer-Indium-Diselenid (CulnSe₂ bzw. CIS) aufgrund seines an das Spektrum des Sonnenlichts angepassten Bandabstands durch einen besonders hohen Absorptionskoeffizienten auszeichnet. Da mit einzelnen Solarzellen nur Spannungspegel von weniger als 1 Volt erreichbar sind, werden viele Solarzellen in einem Solarmodul seriell verschaltet, um eine technisch brauchbare Ausgangsspannung zu erhalten. Dabei bieten Dünnschichtsolarmodule den besonderen Vorteil, dass die Solarzellen schon während der Schichtenherstellung in integrierter Form seriell verschaltet werden können. In der Patentliteratur wurde eine solche integrierte Serienverschaltung von Einzelsolarzellen bereits mehrfach beschrieben. Lediglich beispielhaft sei auf die Patentschrift DE 4324318 C1 verwiesen.

Gewöhnlich erfolgt ein Anschluss des Dünnschichtsolarmoduls an eine elektrische Last mittels einer Anschlussdose, die auf der Rückseite des Solarmoduls angebracht und beispielsweise mit einer Kontaktklemme für die in der Regel in Form von Metallbändern ausgebildeten Anschlusskontakte des Dünnschichtsolarmoduls dienen. Es sind aber auch Dünnschichtsolarmodule mit zwei Anschlussdosen bekannt, um elektrische Verkabelungen innerhalb des Dünnschichtsolarmoduls zu reduzieren.

Demgegenüber besteht die Aufgabe der vorliegenden Erfindung darin, herkömmliche Dünnschichtsolarmodule mit integrierten Solarzellen in vorteilhafter Weise weiterzubilden, wobei insbesondere die Langzeitstabilität und Haltbarkeit des Moduls verbessert und dessen Fertigungskosten verringert werden sollen. Diese und weitere Aufgaben werden nach dem Vorschlag der Erfindung durch eine Solarzellenanordnung beziehungsweise durch ein eine solche Solarzellenanordnung verkörperndes Dünnschichtsolarmodul, sowie durch ein Verfahren zu deren Herstellung mit den Merkmalen der nebengeordneten Patentansprüche gelöst. Vorteilhafte Ausgestaltungen der Erfindung sind durch die Merkmale der Unteransprüche angegeben.

Gemäß einem Aspekt der Erfindung ist eine Solarzellenanordnung mit integrierten, seriell verschalteten Solarzellen gezeigt.

Die erfindungsgemäße Solarzellenanordnung umfasst ein Substrat, auf dem ein über eine Mehrzahl Schichten verfügender Schichtenaufbau aufgebracht ist, der eine erste Elektrodenschicht, eine zweite Elektrodenschicht und eine zwischen den beiden Elektrodenschichten angeordnete Halbleiterschicht umfasst. Es versteht sich, dass diese Aufzählung keineswegs vollständig ist, sondern dass der Schichtenaufbau weitere Schichten enthalten kann. Jede Schicht kann eine oder mehrere Einzellagen umfassen. Durch den Schichtenaufbau wird ein pn-Übergang, d. h. eine Abfolge von Schichten mit unterschiedlichem Leitungstyp gebildet. In besonderen Ausführungsformen wird der pn-Übergang durch einen Heteroübergang gebildet.

In der erfindungsgemäßen Solarzellenanordnung ist der Schichtenaufbau in eine Mehrzahl Bereiche unterteilt, die durch einen oder mehrere Bereichsgräben voneinander elektrisch getrennt sind. Dabei ist in jedem dieser Bereiche ein Solarzellenstrang ausgebildet, der aus einer oder mehreren in Serienschaltung verbundenen, gleichgerichteten Solarzellen besteht. Jede Solarzelle verfügt über eine erste und zweite Elektrode, die in der ersten und zweiten Elektrodenschicht geformt sind, sowie über ein zwischen den beiden Elektroden befindliches Halbleitermaterial, das durch die Halbleiterschicht geformt ist. Von Vorteil kann es sein, wenn einander angrenzende bzw. unmittelbar benachbarte Solarzellenstränge eine anti-parallele Durchlassrichtung aufweisen.

Die erfindungsgemäße Solarzellenanordnung umfasst weiterhin einen ersten Anschlusskontakt und einen zweiten Anschlusskontakt, die durch die Solarzellenstränge elektrisch miteinander verbunden sind. Die Solarzellenstränge sind zu diesem Zweck durch einen oder mehrere Zwischenkontakte seriell verschaltet.

Des Weiteren umfasst die erfindungsgemäße Solarzellenanordnung zumindest ein Anschlussgehäuse (z. B. Anschlussdose), in dem die beiden Anschlusskontakte elektrisch angeschlossen sind. Das Anschlussgehäuse ist zu diesem Zweck mit zumindest einer hierfür geeigneten Einrichtung, beispielsweise eine Klemmeinrichtung, versehen. Das Anschlussgehäuse kann zum Anschluss der Solarzellenanordnung an ein weiteres elektrisches Gerät dienen.

Bei einer vorteilhaften Ausgestaltung der erfindungsgemäßen Solarzellenanordnung, die technisch besonders einfach zu realisieren ist, ist der Schichtenaufbau in zwei Bereiche unterteilt, die durch einen einzigen Bereichsgraben elektrisch voneinander getrennt sind, in denen jeweils ein Solarzellenstrang ausgebildet ist. Vorteilhaft haben die beiden Solarzellenstränge eine anti-parallele Durchlassrichtung. Dabei sind der erste Anschlusskontakt und der zweite Anschlusskontakt durch die beiden Solarzellenstränge elektrisch miteinander verbunden, wobei die beiden Solarzellenstränge durch einen einzigen Zwischenkontakt seriell verschalten sind. Zudem sind die beiden Anschlusskontakte in einem gemeinsamen Anschlussgehäuse elektrisch angeschlossen.

Bei einer weiteren vorteilhaften Ausgestaltung der erfindungsgemäßen Solarzellenanordnung, die technisch besonders einfach zu realisieren ist, ist der Schichtenaufbau in vier Bereiche unterteilt, die durch drei Bereichsgräben elektrisch voneinander getrennt sind, in denen jeweils ein Solarzellenstrang ausgebildet ist. Vorteilhaft haben benachbarte Solarzellenstränge eine anti-parallele Durchlassrichtung. Dabei sind der erste Anschlusskontakt und der zweite Anschlusskontakt durch die vier Solarzellenstränge elektrisch miteinander verbunden sind, wobei die vier Solarzellenstränge durch drei Zwischenkontakte seriell verschalten sind. Zudem sind die beiden Anschlusskontakte jeweils an ein separates Anschlussgehäuse angeschlossen.

In der erfindungsgemäßen Solarzellenanordnung, insbesondere in obigen Ausgestaltungen, können durch Verwenden einer im Vergleich zu herkömmlichen Solarzellenanordnungen geringeren Anzahl von Anschlussgehäusen in vorteilhafter Weise Kosten in der Fertigung eingespart werden. Zudem kann hierdurch die

Langzeitstabilität und Haltbarkeit der Solarzellenanordnung verbessert werden. Weitere Vorteile der Erfindung ergeben sich aus der Figurenbeschreibung.

Bei einer weiteren vorteilhaften Ausgestaltung der erfindungsgemäßen Solarzellenanordnung sind die verschiedenen Bereiche des Schichtenaufbaus, in denen jeweils ein Solarzellenstrang ausgebildet ist, in einer Reihe nebeneinander angeordnet, wobei die beiden Anschlusskontakte in Gegenüberstellung zu zumindest einem Zwischenkontakt angeordnet sind. Von besonderem Vorteil kann es sein, wenn die Solarzellen jeweils streifenförmig ausgebildet sind, wobei die durch einen Zwischenkontakt elektrisch miteinander verbundenen Solarzellenstränge eine zumindest annähernd U-förmige Konfiguration aufweisen können. Ebenso kann es vorteilhaft sein, wenn die Anschluss- und Zwischenkontakte jeweils in Form eines Kontaktbands ausgebildet sind. Durch diese Maßnahmen kann die erfindungsgemäße Solarzellenanordnung in besonders einfacher Weise technisch realisiert werden.

Gemäß einem weiteren Aspekt der Erfindung ist ein Dünnschichtsolarmodul mit integrierten, seriell verschalteten Solarzellen gezeigt, das eine wie oben beschriebene Solarzellenanordnung aufweist, in der jede Solarzelle in Form einer zur photovoltaischen Umwandlung von Sonnenlicht in elektrische Leistung geeigneten Solarzelle ausgebildet ist.

Bei einer vorteilhaften Ausgestaltung des erfindungsgemäßen Solarmoduls sind die Dünnschichtsolarzellen auf einem Trägersubstrat abgeschieden. Das Trägersubstrat kann dem Lichteinfall zugewandt sein, auch als Superstrat-Konfiguration bezeichnet, oder dem Lichteinfall abgewandt sein, auch als Substrat-Konfiguration bezeichnet. In der Substrat-Konfiguration ist die erste Elektrodenschicht in Form einer transparenten Frontelektrodenschicht und die zweite Elektrodenschicht als Rückelektrodenschicht ausgebildet, wobei die Halbleiterschicht auf einer von der Frontelektrodenschicht zugewandten Seite der Rückelektrodenschicht angeordnet ist. Bei der Substrat-Konfiguration kann in besonders vorteilhafter Weise eine Abschattung photovoltaisch aktiver Bereiche durch eine elektrische Verbindung der beiden Anschlusskontakte beispielsweise mit einem gemeinsamen Anschlussgehäuse vermieden werden. Gleichwohl wäre jedoch auch denkbar, für das erfindungsgemäße Dünnschichtsolarmodul die Superstrat-Konfiguration vorzusehen, bei der der Lichteinfall durch ein transparentes Trägersubstrat hindurch erfolgt.

Bei einer weiteren vorteilhaften Ausgestaltung des erfindungsgemäßen Dünnschichtsolarmoduls enthält die Halbleiterschicht aus einer Chalkopyritverbindung, bei der es sich insbesondere um einen 1-111-VI-Halbleiter aus der Gruppe Kupfer-Indium/Gallium-Dischwefel/Diselenid (Cu(InGa)(SSe)₂), beispielsweise Kupfer-Indium-Diselenid (CulnSe₂ bzw. CIS) oder verwandte Verbindungen, handeln kann. Diese enthalten eines oder mehrere der Elemente Cu, In, Ga, Al, Zn, Sn, S, Se oder Te. Ist die Halbleiterschicht Chalkopyrit-basiert, so ist die Substrat-Konfiguration besonders vorteilhaft. Die Halbleiterschicht kann aber auch gemäß der Erfindung Cadmium-Tellurid, amorphes, mikromorphes, mikrokristallines und / oder polykristallines Dünnschichtsilizium enthalten.

Gemäß einem weiteren Aspekt der Erfindung ist ein Verfahren zum Strukturieren eines, eine erste Elektrodenschicht, eine zweite Elektrodenschicht und eine zwischen den beiden Elektrodenschichten angeordnete Halbleiterschicht umfassenden Schichtenaufbaus eines Dünnschichtsolarmoduls gezeigt, das die folgenden Schritte umfasst:
- Erzeugen einer ersten Strukturierungslinie in der zweiten Elektrodenschicht, wodurch die zweite Elektrodenschicht in elektrisch voneinander getrennte zweite Schichtabschnitte unterteilt wird,
- Erzeugen einer zweiten Strukturierungslinie in dem Schichtenaufbau zur elektrischen Verbindung der ersten Elektrodenschicht und der zweiten Elektrodenschicht für eine serielle Verschaltung der Solarzellen,
- Erzeugen einer dritten Strukturierungslinie in der ersten Elektrodenschicht, wodurch die erste Elektrodenschicht in elektrisch voneinander getrennte erste Schichtabschnitte unterteilt wird,
wobei eine Strukturierungslinie, gewählt aus der ersten bis dritten Strukturierungslinie so geführt wird, dass sie einen geradlinigen Verlauf über zumindest zwei elektrisch voneinander getrennte Bereiche hinweg aufweist, während die beiden übrigen Strukturierungslinien diese Strukturierungslinie so versetzt sind und bevorzugt überkreuzt sind, dass eine Abfolge der Strukturierungslinien umgekehrt wird.

Gemäß einem weiteren Aspekt der Erfindung ist ein Verfahren zum Herstellen eines Dünnschichtsolarmoduls gezeigt welches die folgenden Schritte umfasst:
- Aufbringen eines Schichtenaufbaus auf ein Substrat, wobei der Schichtenaufbau zumindest eine erste Elektrodenschicht, eine zweite Elektrodenschicht und eine zwischen den beiden Elektrodenschichten angeordnete Halbleiterschicht aufweist, durch die ein pn-Übergang gebildet ist,
- Strukturieren des Schichtenaufbaus durch ein wie oben beschriebenes Verfahren zum Strukturieren des Schichtenaufbaus eines Dünnschichtsolarmoduls, wobei eine Mehrzahl Solarzellenstränge erzeugt werden, die jeweils aus einer oder mehreren seriell verschalteten, gleichgerichteten Solarzellen bestehen, wobei einander benachbarte Solarzellenstränge vorzugsweise eine anti-parallele Durchlassrichtung haben,
- Einbringen von einem oder mehreren Bereichsgräben in den Schichtenaufbau, derart, dass verschiedene Modulbereiche, die jeweils einen separaten Solarzellenstrang enthalten, elektrisch voneinander getrennt werden,
- Serielles Verschalten der Solarzellenstränge durch Formen eines oder mehrerer Zwischenkontakte,
- Formen eines ersten Anschlusskontakts und eines zweiten Anschlusskontakts, die mit den Solarzellenstränge elektrisch leitend verbunden sind,
- Anschließen der beiden Anschlusskontakte in zumindest einem Anschlussgehäuse.

### Kurze Beschreibung der Zeichnungen

Die Erfindung wird nun anhand von Ausführungsbeispielen näher erläutert, wobei Bezug auf die beigefügten Figuren genommen wird. Es zeigen:
- Fig.1 1: eine schematische Darstellung eines ersten Ausführungsbeispiels des erfindungsgemäßen Dünnschichtsolarmoduls in Draufsicht;
- Fig. 2: schematische Schnittdarstellungen des Dünnschichtsolarmoduls von Fig. 1 im Zwischenbereich (linke Abbildung) und Randbereich (rechte Abbildung);
- Fig. 3: schematische Darstellungen zur Veranschaulichung der Strukturierung des Schichtenaufbaus des erfindungsgemäßen Dünnschichtsolarmoduls von Fig. 1;
- Fig.4A-4B: schematische Darstellungen von Strukturlinien zur Veranschaulichung der Strukturierung des Schichtenaufbaus des erfindungsgemäßen Dünnschichtsolarmoduls von Fig. 1;
- Fig.5A-5B: verschiedene schematische Darstellungen von Strukturlinien zur Veranschaulichung von Varianten zur Strukturierung des Schichtenaufbaus des erfindungsgemäßen Dünnschichtsolarmoduls von Fig. 1;
- Fig. 6: eine schematische perspektivische Darstellung eines zweiten Ausführungsbeispiels des erfindungsgemäßen Dünnschichtsolarmoduls.

### Ausführliche Beschreibung der Zeichnungen

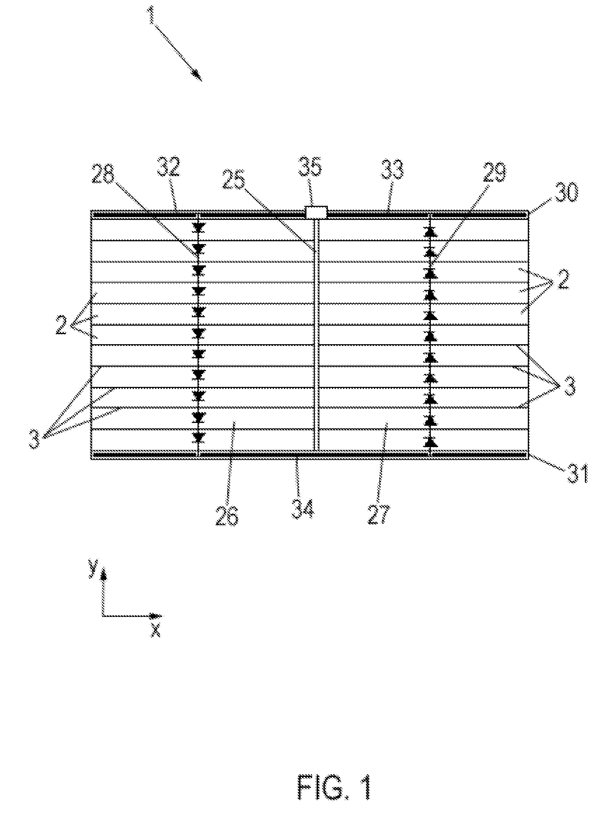

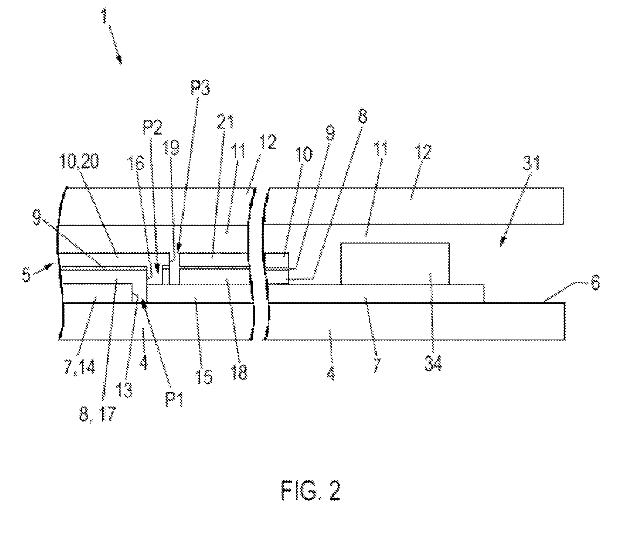

Sei zunächst Bezug auf Fig. 1 und Fig. 2 genommen, worin anhand einer schematischen Aufsicht und verschiedener Schnittdarstellungen ein insgesamt mit der Bezugszahl 1 bezeichnetes Dünnschichtsolarmodul veranschaulicht ist. Das zur photovoltaischen Umwandlung von Sonnenlicht in elektrische Energie dienende Dünnschichtsolarmodul 1 stellt eine Verkörperung der erfindungsgemäßen Solarzellenanordnung dar. Dabei umfasst das Dünnschichtsolarmodul 1 eine Mehrzahl seriell verschalteter, integrierter Solarzellen 2, die eine Verkörperung der Solarzellen der erfindungsgemäßen Solarzellenanordnung darstellen.

Das Dünnschichtsolarmodul 1 hat einen der Substratkonfiguration entsprechenden Aufbau, d.h. es verfügt über ein elektrisch isolierendes Substrat 4 mit einem darauf aufgebrachten Schichtenaufbau 5 aus dünnen Schichten, wobei der Schichtenaufbau 5 auf einer lichteintrittseitigen Hauptoberfläche 6 des Substrats 4 angeordnet ist. Das Substrat 4 besteht hier beispielsweise aus Glas mit einer relativ geringen Lichtdurchlässigkeit, wobei gleichermaßen andere isolierende Materialien mit genügender Festigkeit, sowie inertem Verhalten gegenüber den durchgeführten Prozessschritten eingesetzt werden können.

Der Schichtenaufbau 5 umfasst eine auf der Hauptoberfläche 6 des Substrats 4 angeordnete Rückelektrodenschicht 7, die beispielsweise aus einem lichtundurchlässigen Metall wie Molybdän (Mo) besteht und beispielsweise durch Kathodenzerstäuben auf das Substrat 4 aufgebracht werden kann. Die Rückelektrodenschicht 7 hat beispielsweise eine Schichtdicke von ca. 1 µm. In einer anderen Ausführungsform kann die Rückelektrodenschicht auch aus einem Schichtstapel unterschiedlicher Einzelschichten bestehen. Auf der Rückelektrodenschicht 7 ist eine photovoltaisch aktive Absorberschicht 8 abgeschieden, die aus einem dotierten Halbleiter besteht, dessen Bandabstand vorzugsweise in der Lage ist, einen möglichst großen Anteil des Sonnenlichts zu absorbieren. Die Absorberschicht 8 besteht beispielsweise aus einem p-leitenden Chalkopyrithalbleiter, beispielsweise einer Verbindung der Gruppe Cu(InGa)(SSe)₂, insbesondere Natrium (Na)-dotiertes Kupfer-Indium-Diselenid (CuInSe₂). Die Absorberschicht 8 hat beispielsweise eine Schichtdicke, die im Bereich von 1-5 µm liegt und beispielsweise ca. 2µm beträgt. Auf die Absorberschicht 8 ist eine Pufferschicht 9 abgeschieden, die hier beispielsweise aus einer Einzellage Cadmiumsulfid (CdS) und einer Einzellage intrinsisches Zinkoxid (i-Zn0) besteht, was in den Figuren nicht näher dargestellt ist. Die Pufferschicht 9 hat beispielsweise eine geringere Schichtdicke als die Absorberschicht 8. Auf diese Pufferschicht 9 ist eine Frontelektrodenschicht 10 beispielsweise durch Aufdampfen aufgebracht. Die Frontelektrodenschicht 10 ist für Strahlung im, für die Absorberschicht 8 empfindlichen, Spektralbereich transparent ("Fensterschicht"), um eine nur geringe Schwächung des einstrahlenden Sonnenlichts zu gewährleisten. Die transparente Frontelektrodenschicht 10, die verallgemeinernd als TCO-Schicht (TCO = Transparent Conductive Electrode) bezeichnet werden kann, basiert auf einem dotierten Metalloxid, beispielsweise n-leitendes, Aluminium (A1)-dotiertes Zinkoxid (AZO). Durch die Frontelektrodenschicht 10 wird gemeinsam mit der Pufferschicht 9 und der Absorberschicht 8 ein pn-Heteroübergang (d.h. Abfolge von unterschiedlichen Schichten vom entgegen gesetzten Leitungstyp) gebildet. Die Schichtdicke der Frontelektrodenschicht 10 beträgt beispielsweise ca. 800 nm.

Zum Schutz vor Umwelteinflüssen ist auf der Frontelektrodenschicht 10 eine beispielsweise aus Polyvinylbutyral (PVB) oder Ethylenvinylacetat (EVA) bestehende Kunststoffschicht 11 aufgebracht. Zusätzlich ist der Schichtenaufbau 5 mit einer für Sonnenlicht transparenten Deckplatte 12, die beispielsweise aus extraweißem Glas mit geringem Eisengehalt besteht, versiegelt.

Um die Gesamtmodulspannung zu erhöhen, ist die Modulfläche des Dünnschichtsolarmoduls 1 in eine Vielzahl einzelner Solarzellen 2 aufgeteilt, die in einem ersten Solarzellenstrang 28 und einem zweiten Solarzellenstrang 29 jeweils in Serienschaltung miteinander verbunden sind. Zu diesem Zweck wird der Schichtenaufbau 5 unter Einsatz einer geeigneten Strukturierungstechnologie wie Laserschreiben und mechanische Bearbeitung beispielsweise durch Abheben oder Ritzen, strukturiert. Wichtig hierbei ist, dass die Verluste an photoaktiver Fläche möglichst gering sind und dass die eingesetzte Strukturierungstechnologie selektiv für das zu entfernende Material ist. Eine solche Strukturierung umfasst für jede Solarzelle 3 typischer Weise drei Strukturierungsschritte, die mit den Akronymen P1, P2, P3 abgekürzt werden. Dies wird im Weiteren näher erläutert, wobei Bezug auf Fig. 2, linke Abbildung, genommen wird.

In einem ersten Strukturierungsschritt P1 wird die Rückelektrodenschicht 7 durch Erzeugen eines ersten Schichtgrabens 13 unterbrochen, wobei ein erster Rückelektrodenabschnitt 14 und ein demgegenüber isolierter zweiter Rückelektrodenabschnitt 15 entsteht. Der erste Schichtgraben 13 wird hier vorzugsweise durch Laserschreiben, beispielsweise mittels eines Excimer- oder Neodym-YAG-Lasers, oder durch mechanische Bearbeitung der Rückelektrodenschicht 7 geformt. Der erste Schichtgraben 13 wird vor dem Aufbringen der Absorberschicht 8 geformt und beim Aufbringen der Absorberschicht 8 durch das Halbleitermaterial dieser Schicht verfüllt.

In einem zweiten Strukturierungsschritt P2 werden die beiden halbleitenden Schichten, nämlich die Absorberschicht 8 und die Pufferschicht 9, durch Erzeugen eines zweiten Schichtgrabens 16 unterbrochen, wobei ein erster Halbleiterabschnitt 17 und ein demgegenüber isolierter zweiter Halbleiterabschnitt 18 entsteht. Der zweite Schichtgraben 16 wird hier vorzugsweise durch Laserschreiben, beispielsweise mittels eines Excimer- oder Neodym-YAG-Lasers, geformt. Der zweite Schichtgraben 16 wird vor dem Aufbringen der Frontelektrodenschicht 10 geformt und beim Aufbringen der Frontelektrodenschicht 10 durch das elektrisch leitende Material dieser Schicht verfüllt.

In einem dritten Strukturierungsschritt P3 werden die Frontelektrodenschicht 10, die Pufferschicht 9 und die Absorberschicht 8 durch Erzeugen eines dritten Schichtgrabens 19 unterbrochen, wobei neben den unterbrochenen Abschnitten der halbleitenden Schichten ein erster Frontelektrodenabschnitt 20 und ein demgegenüber isolierte zweiter Frontelektrodenabschnitt 21 entsteht. Der dritte Schichtgraben 19 wird hier vorzugsweise durch mechanische Bearbeitung geformt. Der dritte Schichtgraben 19 wird vor dem Aufbringen der Kunststoffschicht 11 geformt und beim Aufbringen der Kunststoffschicht 11 1 durch das isolierende Material dieser Schicht verfüllt. Alternativ wäre denkbar, dass der dritte Schichtgraben 19 nur die Frontelektrodenschicht 10 unterbricht.

Somit werden durch die drei Strukturierungsschritte P1, P2, P3 zwei seriell verschaltete Solarzellen 2 gebildet, wobei der erste Frontelektrodenabschnitt 20 und der erste Rückelektrodenabschnitt 14 eine Front- bzw. Rückelektrode der einen Solarzelle 2 und der zweite Frontelektrodenabschnitt 21 und der zweite Rückelektrodenabschnitt 15 eine Front- bzw. Rückelektrode der anderen Solarzelle 2 bilden. Dabei ist die Frontelektrode der einen Solarzelle 2 mit der Rückelektrode der anderen Solarzelle 2 elektrisch leitend verbunden.

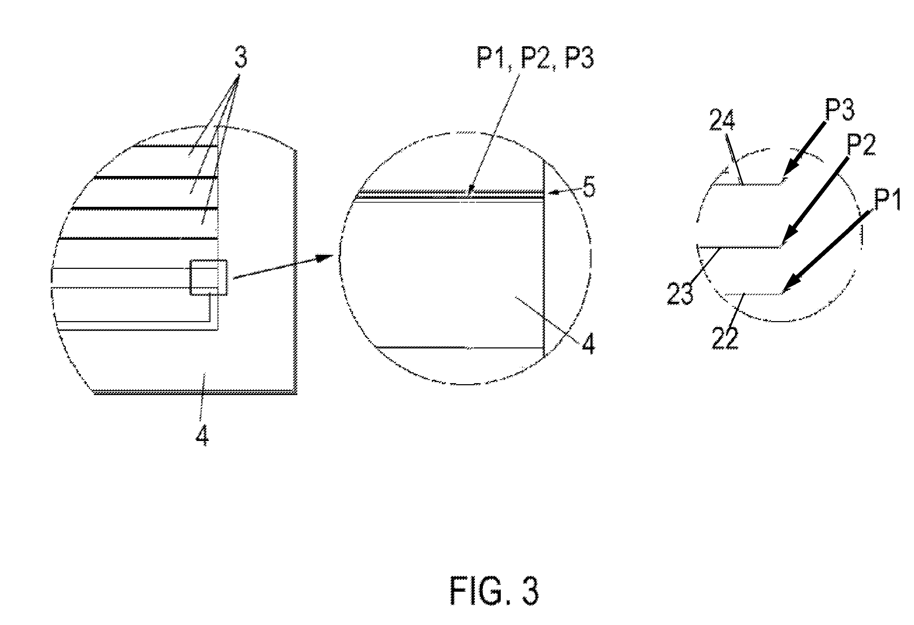

In den Strukturierungsschritten P1, P2, P3 werden die Schichtgräben 13, 16, 19 entlang von Strukturierungslinien geformt, die entsprechend der Benennung der Strukturierungsschritte P1, P2, P3 als erste, zweite und dritte Strukturierungslinien 22-24 bezeichnet werden. In Fig. 3 sind die drei Strukturierungslinien 22-24 schematisch dargestellt, wobei die linke Darstellung eine Aufsicht eines Ausschnitts des Dünnschichtsolarmoduls 1, die mittlere Darstellung einen Detailausschnitt durch das Dünnschichtsolarmodul 1 entsprechend des kenntlich gemachten Gebiets und die rechte Darstellung eine Aufsicht auf eine einzelne Solarzelle 2 zur Veranschaulichung der Strukturierungslinien 22-24 zeigen.

Wie aus Fig. 1 hervorgeht, hat das Dünnschichtsolarmodul 1 eine in Aufsicht rechteckförmige Gestalt, wobei der in entsprechender Weise rechteckförmige Schichtenaufbau 5 durch einen mittigen Bereichsgraben 25, in dem der Schichtenaufbau 5 bis zum Substrat 4 hin komplett entfernt ist, in einen ersten Modulbereich 26 und einen vom ersten Modulbereich 26 elektrisch getrennten, zweiten Modulbereich 27 unterteilt wird. Die beiden Modulbereiche 26, 27 haben eine selbe Form und Größe und sind in einer durch die längere Abmessung des Dünnschichtsolarmoduls 1 bzw. Substrats 4 definierten ersten Richtung (x) nebeneinander angeordnet. Dabei spannt die erste Richtung (x) gemeinsam mit einer hierzu senkrechten, zweiten Richtung (y) eine Ebene auf, die zur Hauptoberfläche 6 des Substrats 4 parallel ist. Erkennbar erstreckt sich der Bereichsgraben 25 geradlinig entlang der zweiten Richtung (y).

Die beiden Modulbereiche 26, 27 verfügen jeweils über einen separaten Solarzellenstrang, wobei im ersten Modulbereich 26 der erste Solarzellenstrang 28 und im zweiten Modulbereich 27 der zweite Solarzellenstrang 29 ausgebildet sind. In den beiden Solarzellensträngen 28, 29 sind die Solarzellen 2 jeweils gleichgerichtet seriell verschaltet, wobei jede Solarzelle 2 durch ein Solarzellensymbol und die Solarzellenstränge 28, 29 durch die verknüpften Solarzellensymbole kenntlich gemacht sind. In Fig. 1 enthält jeder Solarzellenstrang 28, 29 beispielsweise elf Solarzellen 2, wobei es sich versteht, dass diese jeweils eine größere oder geringere Anzahl Solarzellen 2 enthalten können.

Die streifenförmigen Solarzellen 2 erstrecken sich entlang der ersten Richtung (x) und sind entlang der zweiten Richtung (y) angeordnet, wobei benachbarte Solarzellen 2 durch eine entlang der ersten Richtung (x) verlaufende (gedankliche) Trennlinie 3 voneinander getrennt sind, die sich durch die Lage des zugehörigen dritten Schichtengrabens 19 ergibt. Eine Strukturierung der Solarzellen 2 durch die ersten bis dritten Strukturierungslinien 22-24 erfolgt entlang der ersten Richtung (x). Entsprechend sind die Solarzellenstränge 28, 29 jeweils entlang der zweiten Richtung (y), welche der kürzeren Abmessung des Dünnschichtsolarmoduls 1 bzw. Substrats 4 entspricht, seriell verschaltet.

Die beiden Solarzellenstränge 28, 29 haben eine anti-parallele Durchlassrichtung, wobei der erste Solarzellenstrang 28 entlang der negativen zweiten Richtung (-y) und der zweite Solarzellenstrang 29 entlang der positiven zweiten Richtung (y) durchlässig ist. Die Herstellung der anti-parallelen Solarzellenstränge 28, 29 durch die drei Strukturierungsschritte P1, P2, P3 wird weiter unten näher erläutert.

In dem Dünnschichtsolarmodul 1 ist mindestens entlang der ersten Richtung (x) auf beiden Seiten jeweils ein schmaler Randbereich 30, 31 ausgebildet, die unter anderem als Kontaktzonen für die Solarzellenstränge 28, 29 dienen, wobei zu diesem Zweck jeweilige Elektrodenschichten freigelegt sind. So sind in einem ersten Randbereich 30 im ersten Modulbereich 26 ein erster Anschlusskontakt 32 und im zweiten Modulbereich 27 ein dritter Anschlusskontakt 34 geformt, die elektrisch voneinander getrennt sind. In Gegenüberstellung hierzu ist in einem zweiten Randbereich 31 über die beiden Modulbereiche 26, 27 hinweg ein Zwischenkontakt 33 geformt. Die Kontakte 32-34 sind hier beispielsweise in Form von Metallbändern, die insbesondere aus Aluminium bestehen können, ausgebildet.

Dabei ist der erste Anschlusskontakt 32 über den ersten Solarzellenstrang 28 mit dem Zwischenkontakt 34 elektrisch leitend verbunden, wobei - in Entsprechung zur elektrischen Verbindung der Frontelektrode einer vorangehenden Solarzelle 2 mit der Rückelektrode einer nachfolgenden Solarzelle 2 - der erste Anschlusskontakt 32 mit der Frontelektrode der ersten Solarzelle 2 und der Zwischenkontakt 34 mit der Rückelektrode der letzten Solarzelle 2 elektrisch verbunden sind.

Die elektrische Verbindung des Zwischenkontakts 34 mit der Rückelektrode der letzten Solarzelle 2 ist in Fig. 2, rechte Abbildung, bei der es sich um eine Schnittansicht des Dünnschichtsolarmoduls 1 im zweiten Randbereich 31 handelt, erkennbar. Demnach dehnt sich die Rückelektrodenschicht 7 bis in den zweiten Randbereich 31 hinein aus, wobei der Zwischenkontakt 34 auf die Rückelektrodenschicht 7 aufgebracht ist.

Zudem ist der Zwischenkontakt 34 über den zweiten Solarzellenstrang 29 mit dem zweiten Anschlusskontakt 33 elektrisch leitend verbunden, wobei - entsprechend der Verschaltung im ersten Modulbereich 26 - der Zwischenkontakt 34 mit der Frontelektrode der ersten Solarzelle 2 und der zweite Anschlusskontakt 33 mit der Rückelektrode der letzten Solarzelle 2 des zweiten Solarzellenstrangs 29 elektrisch leitend verbunden sind.

Die elektrischen Kontakte 32-34 in den beiden Randbereichen 31, 32 können beispielsweise durch Schweißen, Kleben oder Löten hergestellt werden, bevorzugt durch Ultraschallschweißen. Gemäß der Erfindung werden zum Verbinden freigelegte jeweilige Elektrodenschichten mit den Metallbänder gemäß der Erfindung verschweißt, verklebt oder verlötet und eine elektrisch dauerhaft stabile Verbindung hergestellt wird.

Somit ist im Dünnschichtsolarmodul 1 der erste Anschlusskontakt 32 über die beiden Solarzellenstränge 28, 29, welche über den Zwischenkontakt 34 seriell verschalten sind, mit dem zweiten Anschlusskontakt 33 elektrisch leitend verbunden. In den seriell verschalteten Solarzellensträngen 28, 29 sind alle Solarzellen 2 gleichgerichtet.

Weiterhin ist im ersten Randbereich 30 eine den beiden Solarzellensträngen 28, 29 gemeinsame Anschlussdose 35 vorgesehen, die auf der der Hauptoberfläche 6 entgegen gesetzten Rückseite des Substrats 4 angeordnet und mit einer Einrichtung zum Anschließen der beiden Anschlusskontakte 32, 33 versehen ist. Beispielsweise sind die beiden Anschlusskontakte 32, 33 durch eine lösbare oder feste Vorrichtung mit der Anschlussdose 35 verbunden. Die Anschlussdose 35 dient zum elektrischen Verbinden des Dünnschichtsolarmoduls 1 mit einer elektrischen Last, beispielsweise einen Wechselrichter, was in den Figuren nicht dargestellt ist.

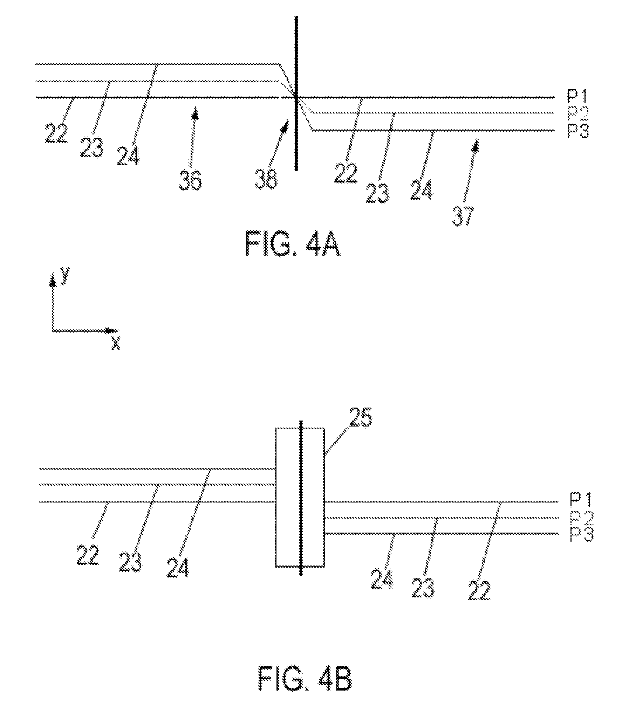

Unter Bezugnahme auf Fig. 4A und 4B wird nun ein Verfahren zum Strukturieren des Schichtenaufbaus 5 bei der Herstellung des Dünnschichtsolarmoduls 1 erläutert.

Demnach wird die erste Strukturierungslinie 22 des Strukturierungsschritts P1 über den vollständigen Schichtenaufbau 5 hinweg entlang der ersten Richtung (x) geradlinig geführt. Im Unterschied hierzu, weisen die beiden übrigen Strukturierungslinien 23, 24 der Strukturierungsschritte P2, P3 in den beiden Modulbereichen 26, 27 entsprechenden Gebieten 36, 37 jeweils eine laterale Versetzung entlang der zweiten Richtung (y) auf. So ist die zweite Strukturierungslinie 23 in einem dem ersten Modulbereich 26 entsprechenden ersten Gebiet 36 des Schichtenaufbaus 5 in positiver zweiter Richtung (y) versetzt zur ersten Strukturierungslinie 22 angeordnet, wohingegen sie in einem dem zweiten Modulbereich 27 entsprechenden zweiten Gebiet 37 des Schichtenaufbaus 5 in negativer zweiter Richtung (-y) versetzt zur ersten Strukturierungslinie 22 angeordnet ist. Andererseits ist die dritte Strukturierungslinie 24 im ersten Gebiet 36 in positiver zweiter Richtung (y) versetzt zur zweiten Strukturierungslinie 23 angeordnet, wohingegen sie im zweiten Gebiet 37 des Schichtenaufbaus 5 in negativer zweiter Richtung (-y) versetzt zur zweiten Strukturierungslinie 23 angeordnet ist. Bevorzugt kreuzen zu diesem Zweck die zweite und dritte Strukturierungslinie 23, 24 jeweils die erste Strukturierungslinie 22 in einem zur Formung des Bereichsgrabens 25 vorgesehenen dritten Gebiet 38, wobei die im ersten Gebiet 36 entlang der positiven zweiten Richtung (y) versetzt zur zweiten Strukturierungslinie 23 angeordnete dritte Strukturierungslinie 24 im zweiten Gebiet 37 entlang der negativen zweiten Richtung (-y) versetzt zur zweiten Strukturierungslinie 23 angeordnet ist. Hierdurch wird die räumliche Abfolge der drei Strukturierungslinien 22-24 im ersten Gebiet 36 gegenüber einer räumlichen Abfolge der drei Strukturierungslinien 22-24 im zweiten Gebiet 37 des Schichtenaufbaus 5 umgekehrt, wobei im ersten Gebiet 36 die erste, zweite und dritte Strukturierungslinie entlang der positiven zweiten Richtung (y) nacheinander angeordnet sind, wohingegen im zweiten Gebiet 37 die dritte, zweite und erste Strukturierungslinie entlang der positiven zweiten Richtung (y) nacheinander angeordnet sind.

In einem weiteren Schritt, wird der Bereichsgraben 25 im dritten Gebiet 38 ausgebildet, wobei zu diesem Zweck der Schichtenaufbau 5 bis zum Substrat 4 hin entfernt wird. Durch Formung des Bereichsgrabens 25 werden die beiden voneinander elektrisch getrennten Modulbereiche 26, 27 gebildet. Der Bereichsgraben 25 wird lediglich im dritten Gebiet 38 des Schichtenaufbaus 5 geformt, in dem schräg zur ersten Richtung (x) verlaufende Abschnitte der Strukturierungslinien 23, 24 vorhanden sind. Wie bereits erwähnt, kann durch die laterale Versetzung der zweiten und dritten Strukturierungslinien 23, 24 entlang der zweiten Richtung (y) in einfacher Weise eine Umkehrung der Abfolge der Strukturierungslinien erzielt werden, was zur Folge hat, dass die Durchlassrichtungen der Solarzellen 2 in den beiden Modulbereichen 25, 26 umgekehrt bzw. anti-parallel gerichtet sind.

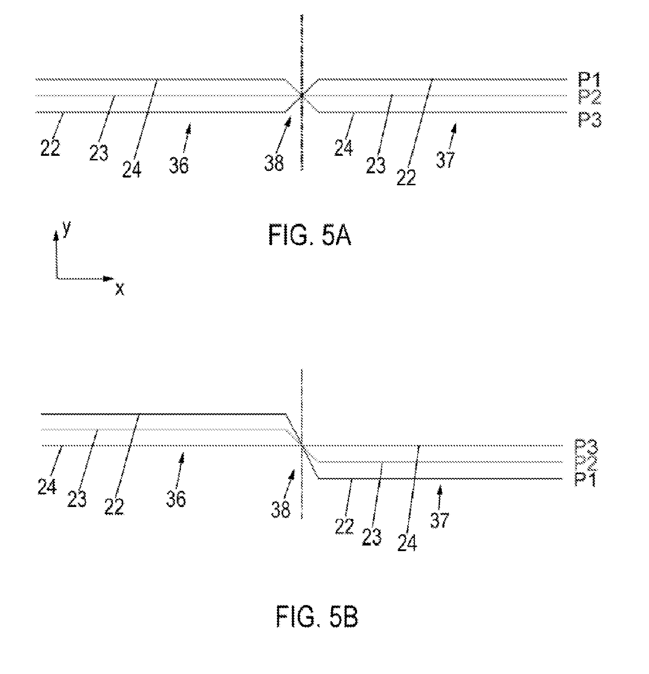

In einer in Fig. 5A veranschaulichten Variante des Verfahrens zur Strukturierung des Schichtenaufbaus 5 wird anstelle der ersten Strukturierungslinie 22 die zweite Strukturierungslinie 23 des Strukturierungsschritts P2 über den vollständigen Schichtenaufbau 5 hinweg entlang der ersten Richtung (x) geradlinig geführt. Im Unterschied hierzu, weisen die beiden übrigen Strukturierungslinien 22, 24 in den ersten und zweiten Gebieten 36, 37 jeweils eine laterale Versetzung entlang der zweiten Richtung (y) auf. Dabei ist die erste Strukturierungslinie 22 im ersten Gebiet 36 des Schichtenaufbaus 5 entlang der negativen zweiten Richtung (-y) versetzt zur zweiten Strukturierungslinie 23 angeordnet, wohingegen sie im zweiten Gebiet 37 des Schichtenaufbaus 5 in positiver zweiter Richtung (y) versetzt zur zweiten Strukturierungslinie 23 angeordnet ist. Andererseits ist die dritte Strukturierungslinie 24 im ersten Gebiet 36 in positiver zweiter Richtung (y) versetzt zur zweiten Strukturierungslinie 23 angeordnet, wohingegen sie im zweiten Gebiet 37 des Schichtenaufbaus 5 in negativer zweiter Richtung (-y) versetzt zur zweiten Strukturierungslinie 23 angeordnet ist. Bevorzugt kreuzen zu diesem Zweck die erste und dritte Strukturierungslinie 22, 24 jeweils die zweite Strukturierungslinie 22 im dritten Gebiet 38. Damit wird die räumliche Abfolge der drei Strukturierungslinien 22-24 im ersten Gebiet 36 gegenüber einer räumlichen Abfolge der drei Strukturierungslinien 22-24 im zweiten Gebiet 37 des Schichtenaufbaus 5 umgekehrt, wobei im ersten Gebiet 36 die erste, zweite und dritte Strukturierungslinie entlang der positiven zweiten Richtung (y) nacheinander angeordnet sind, wohingegen im zweiten Gebiet 37 die dritte, zweite und erste Strukturierungslinie entlang der positiven zweiten Richtung (y) nacheinander angeordnet sind.

In einer in Fig. 5B veranschaulichten weiteren Variante des Verfahrens zur Strukturierung des Schichtenaufbaus 5 wird die dritte Strukturierungslinie 24 über den vollständigen Schichtenaufbau 5 hinweg entlang der ersten Richtung (x) geradlinig geführt. Im Unterschied hierzu, weisen die beiden übrigen Strukturierungslinien 22, 23 in den beiden Gebieten 36, 37 jeweils eine laterale Versetzung entlang der zweiten Richtung (y) auf. Dabei ist die zweite Strukturierungslinie 23 im ersten Gebiet 36 entlang der positiven zweiten Richtung (y) versetzt zur dritten Strukturierungslinie 24 angeordnet, wohingegen sie im zweiten Gebiet 37 in negativer zweiter Richtung (y) versetzt zur dritten Strukturierungslinie 24 angeordnet ist. Andererseits ist die erste Strukturierungslinie 22 im ersten Gebiet 36 in positiver zweiter Richtung (y) versetzt zur zweiten Strukturierungslinie 23 angeordnet, wohingegen sie im zweiten Gebiet 37 in negativer zweiter Richtung (-y) versetzt zur zweiten Strukturierungslinie 23 angeordnet ist. Bevorzugt kreuzen zu diesem Zweck die erste und zweite Strukturierungslinie 22, 23 jeweils die dritte Strukturierungslinie 24 im dritten Gebiet 38. Damit wird die räumliche Abfolge der drei Strukturierungslinien 22-24 im ersten Gebiet 36 gegenüber einer räumlichen Abfolge der drei Strukturierungslinien 22-24 im zweiten Gebiet 37 des Schichtenaufbaus 5 umgekehrt, wobei im ersten Gebiet 36 die erste, zweite und dritte Strukturierungslinie entlang der positiven zweiten Richtung (y) nacheinander angeordnet sind, wohingegen im zweiten Gebiet 37 die dritte, zweite und erste Strukturierungslinie entlang der positiven zweiten Richtung (y) nacheinander angeordnet sind.

Die verschiedenen Varianten des Verfahrens zum Strukturieren des Schichtenaufbaus 5 können Teil eines Verfahrens zur Herstellung des Dünnschichtsolarmoduls 1 sein.

In einer ersten Variante eines beispielhaften Verfahrens zur Herstellung des Dünnschichtsolarmoduls 1 wird die in Fig. 4A und 4B veranschaulichte erste Variante zur Strukturierung des Schichtenaufbaus 5 eingesetzt. Dabei werden die folgenden Schritte sukzessiv durchgeführt:
- Beschichten des Substrats 4 mit der Rückelektrodenschicht 7 (Molybdän);
- Strukturierungsschritt P1 zur Herstellung isolierter Rückelektrodenabschnitte 14, 15 der Rückelektrodenschicht 7, wobei die erste Strukturierungslinie 22 einen geradlinigen Verlauf hat;
- Abscheidung bzw. Bildung der dotierten Absorberschicht 8 (Cu-Ga-In-(Se/S):Na);
- Abscheidung einer ersten Lage der Pufferschicht 9 (CdS); Abscheidung einer zweiten Lage der Pufferschicht 9 (i-Zn0);
- Strukturierungsschritt P2 zur Herstellung einer elektrischen Verbindung zwischen dem Frontelektrodenabschnitt und Rückelektrodenabschnitt benachbarter Solarzellen, wobei die zweite Strukturierungslinie 23 entsprechend Fig. 4A lateral versetzt wird;
- Abscheidung der dotierten Frontelektrodenschicht 10 (ZnO:A)
- Strukturierungsschritt P3 zur Strukturierung der benachbarten Solarzellen 2, wobei die dritte Strukturierungslinie 24 entsprechend Fig. 4A lateral versetzt wird und Entschichtung des Schichtenaufbaus 5 bis zum zur Rückseiten zur Ausbildung von Kontaktzonen innerhalb der beiden Randbereiche 30, 31;
- Entschichtung der beiden Randbereiche 30, 31 ausgenommen der Kontaktzonen und gegebenenfalls weiterer nicht näher bezeichneter Randbereiche entlang des Substrats 4 und Entschichtung des Bereichsgrabens 25 bis zum Substrat 4;
- Herstellen der Zwischen- und Anschlusskontakte 32-34 (AI-Metallstreifen);
- Laminierung des Schichtenaufbaus 5 mit der Kunststoffschicht 11;
- Montage der Anschlussdose 35, sowie Verbinden der Anschlussdose 35 mit den beiden Anschlusskontakten 32,33.

In einer zweiten Variante eines beispielhaften Verfahrens zur Herstellung des Dünnschichtsolarmoduls 1 wird die in Fig. 5A veranschaulichte zweite Variante des Verfahrens zur Strukturierung des Schichtenaufbaus 5 eingesetzt. Dabei werden die folgenden Schritte sukzessiv durchgeführt:
- Beschichten des Substrats 4 mit der Rückelektrodenschicht 7 (Molybdän);
- Strukturierungsschritt P1 zur Herstellung isolierter Rückelektrodenabschnitte 14, 15 der Rückelektrodenschicht 7, wobei die erste Strukturierungslinie 22 entsprechend Fig. 5A lateral versetzt wird;
- Abscheidung bzw. Bildung der dotierten Absorberschicht 8 (Cu-Ga-In-(Se/S):Na);
- Abscheidung einer ersten Lage der Pufferschicht 9 (CdS);
- Abscheidung einer zweiten Lage der Pufferschicht 9 (i-Zn0);
- Strukturierungsschritt P2 zur Herstellung einer elektrischen Verbindung zwischen dem Frontelektrodenabschnitt und Rückelektrodenabschnitt benachbarter Solarzellen, wobei die zweite Strukturierungslinie 23 einen geradlinigen Verlauf hat;
- Abscheidung der dotierten Frontelektrodenschicht 10 (ZnO:A)
- Strukturierungsschritt P3 zur Strukturierung der benachbarten Solarzellen 2, wobei die dritte Strukturierungslinie 24 entsprechend Fig. 5A lateral versetzt wird;
- Entschichtung der beiden Randbereiche 30, 31 und gegebenenfalls weiterer nicht näher bezeichneter Randbereiche entlang der kürzeren Abmessung des Substrats (4) und Entschichtung des Bereichsgrabens 25;
- Herstellen der Zwischen- und Anschlusskontakte 32-34 (AI-Metallstreifen);
- Laminierung des Schichtenaufbaus 5 mit der Kunststoffschicht 11;
- Montage der Anschlussdose 35, sowie Verbinden der Anschlussdose 35 mit den beiden Anschlusskontakten 32,33.

In einer dritten Variante eines beispielhaften Verfahrens zur Herstellung des Dünnschichtsolarmoduls 1 wird die in Fig. 5B veranschaulichte dritte Variante des Verfahrens zur Strukturierung des Schichtenaufbaus 5 eingesetzt. Dabei werden die folgenden Schritte sukzessiv durchgeführt:
- Beschichten des Substrats 4 mit der Rückelektrodenschicht 7 (Molybdän);
- Strukturierungsschritt P1 zur Herstellung isolierter Rückelektrodenabschnitte 14, 15 der Rückelektrodenschicht 7, wobei die erste Strukturierungslinie 22 entsprechend Fig. 5B lateral versetzt wird;
- Abscheidung bzw. Bildung der dotierten Absorberschicht 8 (Cu-Ga-In-(Se/S):Na);
- Abscheidung einer ersten Lage der Pufferschicht 9 (CdS);
- Abscheidung einer zweiten Lage der Pufferschicht 9 (i-Zn0);
- Strukturierungsschritt P2 zur Herstellung einer elektrischen Verbindung zwischen dem Frontelektrodenabschnitt und Rückelektrodenabschnitt benachbarter Solarzellen, wobei die zweite Strukturierungslinie 23 entsprechend Fig. 5B lateral versetzt wird;
- Abscheidung der dotierten Frontelektrodenschicht 10 (ZnO:A)
- Strukturierungsschritt P3 zur Strukturierung der benachbarten Solarzellen 2, wobei die dritte Strukturierungslinie 24 einen geradlinigen Verlauf hat und Entschichtung des Schichtenaufbaus 5 bis zum zur Rückseiten zur Ausbildung von Kontaktzonen innerhalb der beiden Randbereiche 30, 31;
- Entschichtung der beiden Randbereiche 30, 31 ausgenommen der Kontaktzonen und gegebenenfalls weiterer nicht näher bezeichneter Randbereiche entlang des Substrats 4 und Entschichtung des Bereichsgrabens 25 bis zum Substrat 4;
- Herstellen der Zwischen- und Anschlusskontakte 32-34 (AI-Metallstreifen);
- Laminierung des Schichtenaufbaus 5 mit der Kunststoffschicht 11;
- Montage der Anschlussdose 35, Verbinden der Anschlussdose 35 mit den beiden Anschlusskontakten 32,33.

Die verschiedenen Varianten zur Herstellung des Dünnschichtsolarmoduls 1 ermöglichen eine einfache Erzeugung der anti-parallelen Solarzellenstränge 28 29 durch eine geeignete Führung der Strukturierungslinien 22-24 bei der Strukturierung des Schichtenaufbaus 5. Vorteilhaft wird der Bereichsgraben 25 gemeinsam, vorzugsweise gleichzeitig, mit den beiden Randbereichen 30, 31 außerhalb der Kontaktzonen bis zum Substrat entschichtet.

Ein besonderer Vorteil des Dünnschichtsolarmoduls 1 liegt darin, dass nur eine einzige Anschlussdose 35 zum Anschließen der beiden Anschlusskontakte 32, 33 erforderlich ist, wodurch sich die Herstellungskosten vermindern lassen und die Langzeitstabilität und Zuverlässigkeit des Dünnschichtsolarmoduls 1 aufgrund einer korrosiven Fehleranfälligkeit der Anschlussdosen 35 insbesondere durch Eindringen von Feuchtigkeit verbessert ist. Durch die beiden anti-parallel gerichteten Solarzellenstränge 28, 29 sind die beiden Anschlusskontakte 32, 33 auf einer selben Seite des Dünnschichtsolarmoduls 1 angeordnet, so dass in vorteilhafter Weise auf eine aufwändige Verkabelung zum elektrischen Verbinden der beiden Anschlusskontakte 32, 33 mit der gemeinsamen Anschlussdose 35 verzichtet werden kann, welche in der Substratkonfiguration überdies zu einer unerwünschten Abschattung photovoltaisch aktiver Bereiche führen würde. Durch die serielle Verschaltung der beiden Anschlusskontakte 32, 33 mittels der beiden Solarzellenstränge 28, 29, die ihrerseits durch den Zwischenkontakt 34 seriell miteinander verbunden sind, wird eine U-förmige Konfiguration geschaffen.

Die Breite des Bereichsgrabens 25 hängt unter anderem von der Überschlagsspannung der beiden Modulbereiche 26, 27 ab und liegt beispielsweise in einem Bereich von 1 bis 10 mm. Der Bereichsgraben 25 kann mit einem elektrisch isolierenden Material verfüllt werden, um die Überschlagsfestigkeit zu erhöhten. Herstellungstechnisch kann die Breite des Bereichsgrabens 25 von der Schreibgeschwindigkeit der Strukturierungslinien 22-24 abhängen. Die Aufteilung des Dünnschichtsolarmoduls 1 in zwei in etwa gleichgroße Modulbereiche 26, 27 führt zu einer Halbierung des Solarzellenstroms und einer Verdoppelung der Solarzellenspannung. Somit ist der Solarzellenstrom eine Funktion der sich entlang der ersten Richtung (x) bemessende Breite der Solarzellen 2, welche beispielsweise im Bereich von 1 bis 11 mm, vorzugsweise im Bereich von 2 bis 8 mm liegt und insbesondere ca. 5,5 mm beträgt, um eine für die technische Anwendung günstige Strom-/Spannungscharakteristik zu erhalten.

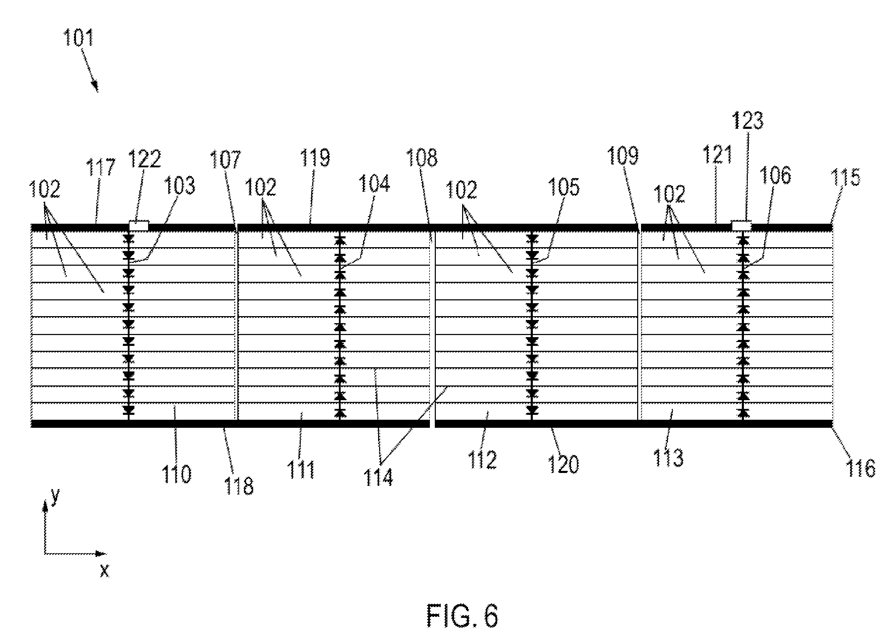

Unter Bezugnahme auf Fig. 6 wird nun ein zweites Ausführungsbeispiel eines insgesamt mit der Bezugszahl 101 bezeichneten erfindungsgemäßen Dünnschichtsolarmoduls 1 beschrieben, wobei zur Vermeidung unnötiger Wiederholungen lediglich die Unterschiede zum ersten Ausführungsbeispiel beschrieben werden und ansonsten auf die dort gemachten Ausführungen Bezug genommen wird.

Demnach ist die Modulfläche des Dünnschichtsolarmoduls 101 in eine Vielzahl einzelner Solarzellen 102 aufgeteilt, die in einem ersten Solarzellenstrang 103, zweiten Solarzellenstrang 104, dritten Solarzellenstrang 105 und vierten Solarzellenstrang 106 jeweils in Serienschaltung miteinander verbunden sind. Dabei ist das Dünnschichtsolarmodul 101, das in Aufsicht eine rechteckige Gestalt hat, in einen ersten Modulbereich 110, zweiten Modulbereich 111, dritten Modulbereich 112 und vierten Modulbereich 113 unterteilt, wobei der erste Modulbereich 110 und der zweite Modulbereich 111 durch einen ersten Bereichsgraben 107, der zweite Modulbereich 111 und der dritte Modulbereich 112 durch einen zweiten Bereichsgraben 108, und der dritte Modulbereich 112 und der vierte Modulbereich 113 durch einen dritten Bereichsgraben 109 elektrisch voneinander getrennt sind. Die Modulbereiche 110-113 haben eine selbe Form und Größe und sind in einer durch die längere Abmessung des Dünnschichtsolarmoduls 101 definierten ersten Richtung (x) in einer Reihe nebeneinander angeordnet. Die Bereichsgräben 107-109 verlaufen jeweils geradlinig entlang der hierzu senkrechten zweiten Richtung (y).

Jeder Modulbereich 110-113 verfügt über einen separaten Solarzellenstrang, wobei im ersten Modulbereich 110 der erste Solarzellenstrang 103, im zweiten Modulbereich 111 der zweite Solarzellenstrang 104, im dritten Modulbereich 112 der dritte Solarzellenstrang 105 und im vierten Modulbereich 113 der vierte Solarzellenstrang 106 ausgebildet sind. In jedem Solarzellenstrang 103-106 sind die Solarzellen 102 jeweils gleichgerichtet seriell verschaltet. Die streifenförmigen Solarzellen 102 erstrecken sich entlang der ersten Richtung (x) und sind entlang der zweiten Richtung (y) angeordnet, wobei benachbarte Solarzellen 103 durch eine entlang der ersten Richtung (x) verlaufende (gedankliche) Trennlinie 114 voneinander getrennt sind. Eine Strukturierung der Solarzellen 102 durch die ersten bis dritten Strukturierungsschritte P1-P3 erfolgt entlang der ersten Richtung (x). Entsprechend sind die Solarzellenstränge 103-106 jeweils entlang der zweiten Richtung (y), welche der kürzeren Abmessung des Dünnschichtsolarmoduls 101 entspricht, seriell verschaltet. In dem Dünnschichtsolarmodul 101 haben benachbarte Solarzellenstränge 103-106 jeweils eine anti-parallele Durchlassrichtung, wobei der erste Solarzellenstrang 103 entlang der negativen zweiten Richtung (-y), der zweite Solarzellenstrang 29 entlang der positiven zweiten Richtung (y), der dritte Solarzellenstrang 105 entlang der negativen zweiten Richtung (-y) und der vierte Solarzellenstrang 106 entlang der positiven zweiten Richtung (y) durchlässig ist.

In dem Dünnschichtsolarmodul 101 ist entlang der ersten Richtung (x) beiderseits jeweils ein schmaler Randbereich 115, 116 ausgebildet, die unter anderem als Kontaktzonen für die Solarzellenstränge 103-106 dienen, wobei zu diesem Zweck jeweilige Elektrodenschichten freigelegt sind. So sind in einem ersten Randbereich 115 im ersten Modulbereich 110 ein erster Anschlusskontakt 117, über den zweiten und dritten Modulbereich 111, 112 hinweg ein zweiter Zwischenkontakt 119, und im vierten Modulbereich 113 ein zweiter Anschlusskontakt 121 geformt, die jeweils elektrisch voneinander getrennt sind. In Gegenüberstellung hierzu ist in einem zweiten Randbereich 116 über den ersten und zweiten Modulbereich 110, 111 hinweg ein erster Zwischenkontakt 118, sowie über den dritten und vierten Modulbereich 112, 113 hinweg ein dritter Zwischenkontakt 120 geformt, die elektrisch voneinander getrennt sind. Die Kontakte 117-121 sind hier beispielsweise in Form von Metallbändern, die insbesondere aus Aluminium bestehen können, ausgebildet. Dabei ist der erste Anschlusskontakt 117 über den ersten Solarzellenstrang 103 mit dem ersten Zwischenkontakt 118 elektrisch leitend verbunden, der erste Zwischenkontakt 118 über den zweiten Solarzellenstrang 104 mit dem zweiten Zwischenkontakt 119 elektrisch leitend verbunden, der zweite Zwischenkontakt 119 über den dritten Solarzellenstrang 105 mit dem dritten Zwischenkontakt 120 elektrisch leitend verbunden, und der dritte Zwischenkontakt 120 über den vierten Solarzellenstrang 106 mit dem zweiten Anschlusskontakt 121 elektrisch leitend verbunden.

Somit ist im Dünnschichtsolarmodul 101 der erste Anschlusskontakt 117 über die vier seriell verschalteten Solarzellenstränge 103-106 mit dem zweiten Anschlusskontakt 121 elektrisch leitend verbunden. In den seriell verschalteten Solarzellensträngen 103-106 sind alle Solarzellen 102 gleichgerichtet.

Weiterhin ist im ersten Randbereich 115 im ersten Modulbereich 110 eine an den ersten Anschlusskontakt 117 angeschlossene erste Anschlussdose 122 vorgesehen, die auf der Rückseite des Dünnschichtsolarmoduls 101 angeordnet ist und mit einer Einrichtung zum Anschließen des ersten Anschlusskontakts 117 versehen ist. Zudem ist im ersten Randbereich 115 im vierten Modulbereich 113 eine an den zweiten Anschlusskontakt 121 angeschlossene zweite Anschlussdose 123 vorgesehen, die gleichermaßen auf der Rückseite des Dünnschichtsolarmoduls 101 angeordnet und mit einer Einrichtung zum Anschließen des zweiten Anschlusskontakts 121 versehen ist. Die beiden Anschlussdosen 122, 123 dienen zum elektrischen Verbinden des Dünnschichtsolarmoduls 101 mit einer elektrischen Last, beispielsweise einen Wechselrichter.

Alternativ können auch in dieser Konfiguration die Anschlusskontakte 117 und 121 auch in einer Anschlussdose 122, 123 angeschlossen werden.

Die Herstellung der anti-parallelen Solarzellenstränge 103-106 kann entsprechend einer anhand der Figuren 4A, 4B, 5A und 5B erläuterten lateralen Versetzung der Strukturierungslinien in den drei Strukturierungsschritten P1-P3 erfolgen, wobei eine Umkehrung einer entlang der negativen zweiten Richtung (-y) gerichteten Solarzellenstrang-Richtung in eine entlang der positiven zweiten Richtung (y) gerichteten Solarzellenstrang-Richtung durch den geradlinige Verlauf einer Strukturierungslinie und die in den Figuren dargestellte laterale Versetzung der beiden anderen Strukturierungslinien erreicht wird, während eine Umkehrung einer entlang der positiven zweiten Richtung (y) gerichteten Solarzellenstrang-Richtung in eine entlang der negativen zweiten Richtung (-y) gerichteten Solarzellenstrang-Richtung durch eine bezüglich der geradlinigen Strukturierungslinie spiegelverkehrte laterale Versetzung der beiden anderen Strukturierungslinien erreicht wird. Das in Fig. 6 gezeigte Dünnschichtsolarmodul 101 kann durch die oben dargestellten Varianten der Herstellungsverfahren gefertigt werden, wobei ein solches Strukturierungsverfahren zur Anwendung kommt, durch das eine einfache Erzeugung der anti-parallelen Solarzellenstränge 103-106 ermöglicht ist. Vorteilhaft werden die Bereichsgräben 107-109 gemeinsam, vorzugsweise gleichzeitig, mit den beiden Randbereichen 115, 116 entschichtet.

Ein besonderer Vorteil des Dünnschichtsolarmoduls 101 liegt darin, dass pro Paar anti-parallel gerichteter Solarzellenstränge 103-106 nur eine einzige Anschlussdose 122, 123 zum Anschließen eines Anschlusskontakts 117, 121 erforderlich ist, wodurch sich die Herstellungskosten vermindern lassen und die Langzeitstabilität und Zuverlässigkeit des Dünnschichtsolarmoduls 101 verbessert ist. Durch die serielle Verschaltung der beiden Anschlusskontakte 117, 121 durch die vier Solarzellenstränge 103-106, die ihrerseits durch die Zwischenkontakte 118-120 seriell miteinander verbunden sind, wird eine aus mehreren verschaltenen U's bestehende Konfiguration geschaffen, die eine aufwändige Verkabelung verzichtbar macht. Durch die Einstellung von Anzahl und Größe der Modulbereiche 110-113, insbesondere der Anzahl der seriell verschalteteten U's, kann auf die Strom-/Spannungscharakteristik des Dünnschichtsolarmoduls 101 gezielt Einfluss genommen werden. Obgleich in Fig. 6 ein Dünnschichtsolarmodul 101 mit vier Modulbereichen 110-113 gezeigt ist, versteht es sich, dass eine größere oder kleinere Anzahl von Modulbereichen vorgesehen sein kann. Dabei ist es bevorzugt, wenn eine gerade Anzahl von Modulbereichen vorliegt, wobei benachbarte Solarzellenstränge eine anti-parallele Durchlassrichtung haben.

Die Erfindung stellt ein Dünnschichtsolarmodul zur Verfügung, das in der industriellen Serienfertigung kostengünstig herstellbar ist und dessen Langzeitstabilität und Haltbarkeit gegenüber herkömmlichen Dünnschichtsolarmodulen verbessert ist. Auf die Strom-/Spannungscharakteristik des Dünnschichtsolarmoduls kann in gewünschter Weise gezielt Einfluss genommen werden.

### Bezugszeichenliste

- 1: Dünnschichtsolarmodul
- 2: Solarzelle
- 3: Trennlinie
- 4: Substrat
- 5: Schichtenaufbau
- 6: Hauptoberfläche
- 7: Rückelektrodenschicht
- 8: Absorberschicht
- 9: Pufferschicht
- 10: Frontelektrodenschicht
- 11: Kunststoffschicht
- 12: Deckplatte
- 13: erster Schichtgraben
- 14: erster Rückelektrodenabschnitt
- 15: zweiter Rückelektrodenabschnitt
- 16: zweiter Schichtgraben
- 17: erster Halbleiterabschnitt
- 18: zweiter Halbleiterabschnitt
- 19: dritter Schichtgraben
- 20: erster Frontelektrodenabschnitt
- 21: zweiter Frontelektrodenabschnitt
- 22: erste Strukturierungslinie
- 23: zweite Strukturierungslinie
- 24: dritte Strukturierungslinie
- 25: Bereichsgraben
- 26: erster Modulbereich
- 27: zweiter Modulbereich
- 28: erster Solarzellenstrang
- 29: zweiter Solarzellenstrang
- 30: erster Randbereich
- 31: zweiter Randbereich
- 32: erster Anschlusskontakt
- 33: zweiter Anschlusskontakt
- 34: Zwischenkontakt
- 35: Anschlussdose
- 36: erstes Gebiet
- 37: zweites Gebiet
- 38: drittes Gebiet
- 101: Dünnschichtsolarmodul 102 Solarzelle
- 103: erster Solarzellenstrang
- 104: zweiter Solarzellenstrang
- 105: dritter Solarzellenstrang
- 106: vierter Solarzellenstrang
- 107: erster Bereichsgraben
- 108: zweiter Bereichsgraben
- 109: dritter Bereichsgraben
- 110: erster Modulbereich
- 111: zweiter Modulbereich
- 112: dritter Modulbereich
- 113: vierter Modulbereich 114 Trennlinie
- 115: erster Randbereich
- 116: zweiter Randbereich
- 117: erster Anschlusskontakt
- 118: erster Zwischenkontakt
- 119: zweiter Zwischenkontakt
- 120: dritter Zwischenkontakt
- 121: zweiter Anschlusskontakt
- 122: erste Anschlussdose
- 123: zweite Anschlussdose

## Patentansprüche

1. Solarzellenanordnung (1; 101), insbesondere für Dünnschichtsolarmodule, welche ein Substrat (4) umfasst, auf dem ein über mehrere Schichten (7-10) verfügender Schichtenaufbau (5) aufgebracht ist, wobei der Schichtenaufbau (5) in eine Mehrzahl verschiedener Bereiche (26, 27; 110-113) unterteilt ist, die durch einen oder mehrere Bereichsgräben (25; 107-109) elektrisch voneinander getrennt sind, wobei in jedem Bereich (26, 27; 110-113) ein Solarzellenstrang (28, 29; 103-106) ausgebildet ist, der aus einer oder mehreren seriell verschalteten, gleichgerichteten Solarzellen (2, 102) besteht.

2. Solarzellenanordnung (1; 101) nach Anspruch 1, wobei die Solarzellenstränge (28, 29; 103 - 06) durch einen oder mehrere Zwischenkontakte (34; 118 - 120) seriell verschaltet sind.

3. Solarzellenanordnung (1; 101) nach einem der Ansprüche 1 oder 2, wobei der Schichtenaufbau (5) eine erste Elektrodenschicht (10), eine zweite Elektrodenschicht (7) und eine zwischen den beiden Elektrodenschichten (7, 10) angeordnete Halbleiterschicht (8) aufweist, durch die ein pn-Übergang gebildet ist, bei welchem die Halbleiterschicht (8) aus einer Chalkopyritverbindung, Cadmium-Tellurid und/ oder Silizium gebildet wird.

4. Solarzellenanordnung (1; 101) nach einem der Ansprüche 1 bis 3, mit einem ersten Anschlusskontakt (32; 117) und einem zweiten Anschlusskontakt (33; 121), die durch die Solarzellenstränge (28, 29; 103-106) elektrisch miteinander verbunden sind, wobei die Solarzellenstränge (28, 29; 103-106) durch einen oder mehrere Zwischenkontakte (34; 118-120) seriell verschalten sind, zumindest ein Anschlussgehäuse (35; 122, 123), in dem die beiden Anschlusskontakte (32, 33; 117, 121) angeschlossen sind.

5. Solarzellenanordnung (1) nach Anspruch 4, bei welcher:
- der Schichtenaufbau in zwei Bereiche (26, 27) unterteilt ist, die durch einen Bereichsgraben (25) elektrisch voneinander getrennt sind,
- der erste Anschlusskontakt (32) und der zweite Anschlusskontakt (33) durch die beiden Solarzellenstränge (28, 29) elektrisch miteinander verbunden sind, wobei die beiden Solarzellenstränge (28, 29) durch einen Zwischenkontakt (34) seriell verschaltet sind,
- die beiden Anschlusskontakte (32, 33) an ein gemeinsames Anschlussgehäuse (35) angeschlossen sind.

6. Solarzellenanordnung (101) nach Anspruch 4, bei welcher:
- der Schichtenaufbau in vier Bereiche (110-113) unterteilt ist, die durch drei Bereichsgräben (107-109) elektrisch voneinander getrennt sind,
- der erste Anschlusskontakt (117) und der zweite Anschlusskontakt (121) durch die vier Solarzellenstränge (103-106) elektrisch miteinander verbunden sind, wobei die vier Solarzellenstränge (103-106) durch drei Zwischenkontakte (118-120) seriell verschalten sind,
- die beiden Anschlusskontakte (117, 121) jeweils an ein separates Anschlussgehäuse (122, 123) angeschlossen sind.

7. Solarzellenanordnung (1; 101) nach einem der Ansprüche 1 bis 6, bei welcher die Solarzellen (2, 102) jeweils streifenförmig ausgebildet sind.

8. Solarzellenanordnung (1; 101) nach einem der Ansprüche 1 bis 7, bei welcher die Anschluss- und Zwischenkontakte (32-34; 117-121 ) jeweils in Form eines Kontaktbands ausgebildet sind.

9. Solarzellenanordnung (1; 101) nach einem der Ansprüche 1 bis 8, bei welcher der zumindest eine Bereichsgraben (25; 107-109) eine sich quer zu seiner Erstreckung bemessende Breite im Bereich von 0,5 bis 10 mm, insbesondere 1 bis 3 mm aufweist.

10. Solarzellenanordnung (1; 101) nach einem der Ansprüche 1 bis 9, bei welcher der zumindest eine Bereichsgraben (25; 107-109) mit einem elektrisch isolierenden Material verfüllt ist.

11. Dünnschichtsolarmodul (1; 101), welches in Form einer Solarzellenanordnung nach einem der Ansprüche 1 bis 10 ausgebildet ist.

12. Dünnschichtsolarmodul (1; 101) nach Anspruch 11, bei welchem die erste Elektrodenschicht (10) eine transparente Frontelektrodenschicht und die zweite Elektrodenschicht (7) eine Rückelektrodenschicht ist, wobei das Substrat (4) auf einer von der Frontelektrodenschicht abgewandten Seite der Rückelektrodenschicht angeordnet ist.

13. Verfahren zum Strukturieren eines, eine erste Elektrodenschicht (10), eine zweite Elektrodenschicht (7) und eine zwischen den beiden Elektrodenschichten (7, 10) angeordnete Halbleiterschicht (8) umfassenden Schichtenaufbaus (5) eines Dünnschichtsolarmoduls (1,101), mit den folgenden Schritten:
- Erzeugen einer ersten Strukturierungslinie (22) in der zweiten Elektrodenschicht (7), wodurch die zweite Elektrodenschicht (7) in elektrisch voneinander getrennte zweite Schichtabschnitte (14, 15) unterteilt wird,
- Erzeugen einer zweiten Strukturierungslinie (23) zur elektrischen Verbindung der ersten Elektrodenschicht (10) und der zweiten Elektrodenschicht (7) für eine serielle Verschaltung der Solarzellen,
- Erzeugen einer dritten Strukturierungslinie (24) in der ersten Elektrodenschicht (10), wodurch die erste Elektrodenschicht (10) in elektrisch voneinander getrennte erste Schichtabschnitte (20, 21) unterteilt wird,
wobei eine Strukturierungslinie, gewählt aus der ersten bis dritten Strukturierungslinie (22 - 24) so geführt wird, dass sie einen geradlinigen Verlauf über zumindest zwei elektrisch voneinander getrennte Bereiche (26, 27; 110-113) hinweg aufweist, während die beiden übrigen Strukturierungslinien diese Strukturierungslinie so zueinander versetzt sind, dass eine Abfolge der Strukturierungslinien (22-24) umgekehrt wird.

14. Verfahren nach Anspruch 13, wobei eine Strukturierungslinie, gewählt aus der ersten bis dritten Strukturierungslinie (22-24) so geführt wird, dass sie einen geradlinigen Verlauf über zumindest zwei elektrisch voneinander getrennte Bereiche (26, 27; 110-113) hinweg aufweist, während die beiden übrigen Strukturierungslinien diese Strukturierungslinie so überkreuzen, dass eine Abfolge der Strukturierungslinien (22-24) umgekehrt wird.

15. Verfahren zum Herstellen eines Dünnschichtsolarmoduls (1, 101), welches die folgenden Schritte umfasst:
- Aufbringen eines Schichtenaufbaus (5) auf ein Substrat (4), wobei der Schichtenaufbau (5) zumindest eine erste Elektrodenschicht (10), eine zweite Elektrodenschicht (7) und eine zwischen den beiden Elektrodenschichten (7, 10) angeordnete Halbleiterschicht (8) aufweist, durch die ein pn-Übergang gebildet ist,
- Strukturieren des Schichtenaufbaus (5) durch ein Verfahren nach Anspruch 14, derart, dass eine Mehrzahl Solarzellenstränge (28, 29; 103-106) erzeugt werden, die jeweils aus einer oder mehreren seriell verschalteten, gleichgerichteten Solarzellen (2, 102) bestehen, wobei einander benachbarte Solarzellenstränge insbesondere eine anti-parallele Durchlassrichtung haben können,
- Einbringen von einem oder mehreren Bereichsgräben (25; 107-109) in den Schichtenaufbau (5), derart, dass verschiedene Modulbereiche (26, 27; 110-113), die jeweils einen separaten Solarzellenstrang enthalten, elektrisch voneinander getrennt werden,
- Serielles Verschalten der Solarzellenstränge (28, 29; 103-106) durch Formen eines oder mehrerer Zwischenkontakte (34; 118-120),
- Formen eines ersten Anschlusskontakts (32; 117) und eines zweiten Anschlusskontakts (33; 121), die mit den Solarzellenstränge (28, 29; 103-106) elektrisch leitend verbunden sind,
- Anschließen der beiden Anschlusskontakte (32, 33; 117, 121) in zumindest einem Anschlussgehäuse (35; 122, 123).
